# EUROPEAN PATENT APPLICATION

(11) **EP 3 968 747 A1**
(43) Date of publication of application: **16.03.2022**
(21) Application number: 21188348.3
(22) Date of filing: 28.07.2021
(51) Int. Cl.: H05K 7/20

(54) **DRAWER-TYPE MODULE SEALING STRUCTURE OF INVERTER**

(30) Priority: 09.09.2020 CN 202021957062 U
(71) Applicant: Sungrow Power Supply Co., Ltd., Hefei, Anhui 230088 (CN)
(72) Inventor: Wang, Xiaohu, Hefei, Anhui 230088 (CN); Zheng, Hao, Hefei, Anhui 230088 (CN); Wu, Fei, Hefei, Anhui 230088 (CN)
(74) Representative: Zacco Norway AS

(57) **Abstract**

The present application relates to the field of electrical technology, in particular to a drawer-type module sealing structure of an inverter, which includes a power module, a first annular sealing, a second annular sealing ring and a fan connector. An upper end surface of the power module is a first inclined plane, and an upper end of the power module includes a first vent, and a lower end of the power module includes a second vent. The first annular sealing ring is arranged at the first vent. The second annular sealing ring is arranged at the second vent. The fan connector is arranged at the upper end of the power module, and a lower end surface of the fan connector is a second inclined plane which can cooperate with the first inclined plane, and the second inclined plane abuts against the first annular sealing ring. The present application can improve the sealing effect of a radiator, so as to enhance the protection ability of a cabinet.

## Description

### FIELD

The present application relates to the field of electrical technology, and in particular to a drawer-type module sealing structure of an inverter.

### BACKGROUND

A photovoltaic grid-connected inverter is used as an interface device between a solar power generation system and a power grid. With the step-by-step realization of grid parity for a large-scale photovoltaic power station, the demand for the photovoltaic grid-connected inverter with higher power has become increasingly strong. Higher power means lower cost per watt, and the effect of grid parity is becoming more and more apparent.

The high-power photovoltaic inverter is generally applied in a harsh environment, thus the protection requirements for the inverter are getting higher and higher, and the impact of sand, dust and moisture on the internal components of the inverter is increasing. A power module on the inverter is the core component of the entire inverter and requires a high frequency of maintenance. In the design structure, the power module needs to be highly maintainable, and is convenient to disassemble and maintain the inverter.

A power device in the power module generates a lot of heat, and a radiator needs to be mounted at the rear to dissipate heat, and the radiator needs external air to dissipate heat. The radiator is in a high-pressure air environment, and the outside air brings a lot of dust. If the radiator is not well sealed, a large amount of external dust may enter the cabinet through the module radiator structure under the action of high-pressure air, which may reduce the protection capability of the whole machine. In the conventional technology, a non-closed seal is generally used to seal the radiator. Although it can play a certain sealing role, dust can still enter the cabinet and damage the protection of the whole machine since the seal itself is non-closed.

Therefore, a drawer-type module sealing structure of an inverter is needed to solve the above technical problems.

### SUMMARY

A drawer-type module sealing structure of an inverter is provided by the present application, which can improve the sealing effect of a radiator, thereby enhancing the protection capability of a cabinet.

The following technical solutions are used by the present application: a drawer-type module sealing structure of an inverter includes a power module, a first annular sealing ring, a second annular sealing ring and a fan connector. The power module includes a first vent, and a lower end of the power module includes a second vent. The first annular sealing ring arranged at the first vent. The second annular sealing ring arranged at the second vent. The fan connector is arranged at the upper end of the power module, and a lower end surface of the fan connector is a second inclined plane which is configured to cooperate with the first inclined plane, and the second inclined plane is abutted against the first annular sealing ring.

Further, the drawer-type module sealing structure of the inverter, includes a guide rail, the power module is slidably arranged on the guide rail, and the second annular sealing ring abuts against the guide rail.

Further, the power module includes a module and a radiator, the radiator is arranged on the module, an upper end of the radiator includes the first vent, a lower end of the radiator includes the second vent, and the module is slidably connected to the guide rail.

Further, a lower end surface of the power module is a third inclined plane, and an upper end surface of the guide rail is a fourth inclined plane which is configured to cooperate with the third inclined plane.

Further, an abutting member abutting against the second annular sealing ring is arranged on the guide rail, the abutting member is obliquely arranged and is configured to cooperate with the third inclined plane.

Further, an air duct docking interface is defined on the guide rail, the air duct docking interface is directly communicated with the second vent, and the abutting member is arranged along a circumferential direction of the air duct docking interface.

Further, the module and the radiator have an integrated structure.

Further, a lower end surface of the module is provided with a supporting plate, and the supporting plate is slidably connected to the guide rail.

Further, an angle between the first inclined plane and the horizontal plane and an angle between the third inclined plane and the horizontal plane both range from 1.5 degrees to 5 degrees.

Further, the first annular sealing ring and the second first annular sealing ring are both made of rubber.

The beneficial effects according to the present application are that:
in the drawer-type module sealing structure of the inverter provided according to the present application, the upper end surface of the power module is arranged as the first inclined surface, the first annular sealing ring is arranged at the first vent, the second annular sealing ring is arranged at the second vent, the lower end surface of the fan connector is the second inclined plane which is configured to cooperate with the first inclined plane, and the second inclined plane abuts against the first annular sealing ring. Since the second inclined plane is able to cooperate with the first inclined plane and plays a role of chocking, the first annular sealing ring is elastically deformed to enhance the sealing. By arranging the first annular sealing ring and the second annular sealing ring, dust is prevented from entering the cabinet through the first vent and the second vent, which improves the sealing effect of the radiator, and enhances the protection capability of the cabinet.

### BRIEF DESCRIPTION OF THE DRAWINGS

FIG. 1 is a schematic diagram of a drawer-type module sealing structure of an inverter according to the present application;
FIG. 2 is a left exploded view of the drawer-type module sealing structure of the inverter according to the present application;
FIG. 3 is an exploded view of the drawer-type module sealing structure of the inverter according to the present application;

The reference numerals in the figures are:

| | | | |
|---|---|---|---|
| 1 | power module; | 11 | module; |
| 111 | supporting plate; | 12 | first vent; |
| 2 | fan connector; | 21 | second inclined plane; |
| 3 | first annular sealing ring; | 4 | second annular sealing ring; |
| 5 | guide rail; | 51 | abutting member; |
| 52 | air duct docking interface. | | |

### DETAILED DESCRIPTION OF THE EMBODIMENTS

The technical solutions according to the present disclosure will be described as follows in conjunction with the drawings and the embodiments. It can be understood that the specific embodiments described here are used to explain the present application, but not to limit the present application. In addition, it should be noted that, for the convenience of description, only parts but not all parts related to the present disclosure are shown in the drawings.

In the description of the present application, it should be noted that, unless otherwise clearly specified and limited, the terms "mounting", "connection" or "communication" should be understood in a broad sense. For example, it may be a fixed connection or a detachable connection; it may be a mechanical connection or an electrical connection; it may be a direct connection, or an indirect connection through an intermediate medium, or an internal communication between two components. For those skilled in the art, the specific meaning of the above terms in the present application can be understood under specific circumstances.

In the present application, unless otherwise clearly specified and limited, the first feature "above" or "below" the second feature may include that the first and the second features are in direct contact, or may include that the first and the second features are not in direct contact but are contacted through other feature between the first and the second features. Moreover, the first feature is "above", "over" and "on top of' the second feature includes that the first feature directly above and obliquely above the second feature, or simply means that the horizontal height of the first feature is greater than that of the second feature. The first feature is "under", "below " and "at the bottom of' the second feature includes that the first feature is directly below and obliquely below the second feature, or simply means that the horizontal height of the first feature is smaller than that of the second feature.

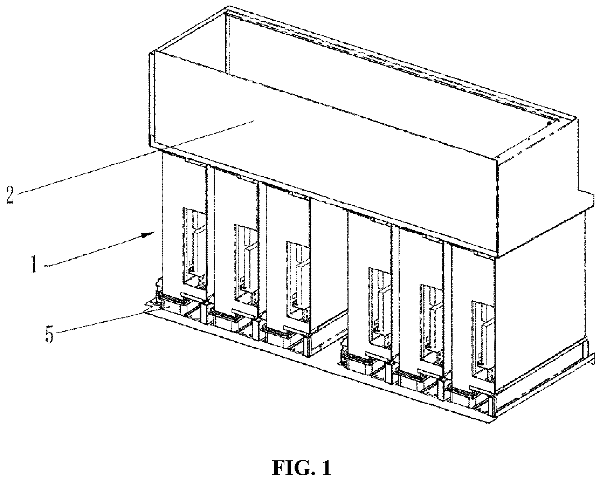

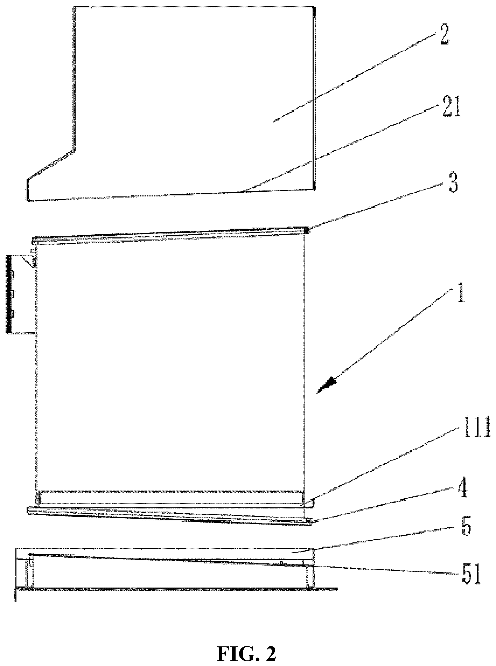

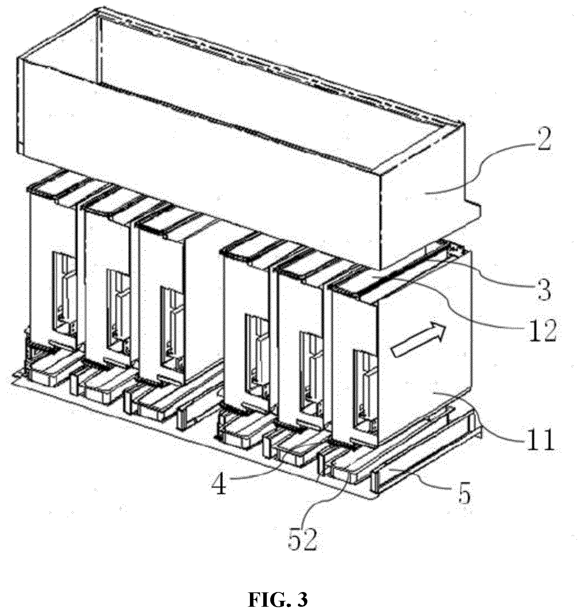

In order to improve the sealing effect of a radiator, and further improve the protection capability of a cabinet, as shown in FIG. 1 to 3, a drawer-type module sealing structure of an inverter provided according to the present application includes a power module 1, a first annular sealing ring 3, a second annular sealing ring 4, a fan connector 2 and a guide rail 5. An upper end surface of the power module 1 is a first inclined plane, and an upper end of the power module 1 includes a first vent 12, and a lower end of the power module 1 includes a second vent. The first annular sealing ring 3 is arranged at the first vent 12. The second annular sealing ring 4 is arranged at the second vent. A fan cavity communicated with the first vent 12 is defined in the fan connector 2, the fan connector 2 is arranged at the upper end of the power module 1, and a lower end surface of the fan connector 2 is a second inclined plane 21 which is able to cooperate with the first inclined plane, and the second inclined plane 21 abuts against the first annular sealing ring 3. The power module 1 is slidably arranged on the guide rail 5, and the second annular sealing ring 4 abuts against the guide rail 5.

When the power module 1 slide relative to the guide rail 5 and retracts relative to the fan connector 2, the first annular sealing ring 3 is elastically deformed to enhance the sealing since the second inclined plane 21 cooperates with the first inclined plane and plays a role of chocking. By arranging the first annular sealing ring 3 and the second annular sealing ring 4, dust is prevented from entering the cabinet through the first vent 12 and the second vent, which improves the sealing effect of the radiator, and enhances the protection capability of the cabinet.

Specifically, when the power module 1 is drawn, sharp edges formed by splicing gaps on the power module 1 may be apt to damage the sealing ring and affect the life of the sealing ring. Therefore, the first annular sealing ring 3 is arranged at the first vent 12, and the second annular sealing ring 4 is arranged at the second vent. When the power module 1 is drawn, the first annular sealing ring 3 rubs against the fan connector 2. Since the lower end surface of the fan connector 2 is relatively flat and smooth, the first annular sealing ring 3 is ensured not to be scratched, and the service lift of the first annular sealing ring 3 is prolonged. The second annular sealing ring 4 rubs against a flat and smooth surface of the guide rail 5, which ensures the second annular sealing ring 4 to be not scratched, and the service lift of the second annular sealing ring 4 is prolonged.

Further, the power module 1 includes a module 11 and a radiator, the radiator is arranged on the module 11, an upper end of the radiator includes the first vent 12, a lower end of the radiator includes the second vent, and the module 11 is slidably connected to the guide rail 5. The heat generated by the module 11 is dissipated through the radiator, so as to ensure the module 11 to work normally. Specifically, in order to facilitate manufacturing, the module 11 and the radiator have an integrated structure.

Further, a lower end surface of the power module 1 is a third inclined plane, and an upper end surface of the guide rail 5 is a fourth inclined plane which is able to cooperate with the third inclined plane. Through the cooperation of the third inclined plane and the fourth inclined plane, the second annular sealing ring 4 is compressed and deformed when the power module 1 is retracted, so as to ensure the sealing effect of the second vent. At the same time, since the third inclined plane cooperates with the fourth inclined plane and plays a role of chocking, the sealing performance of the second vent is improved.

Further, an abutting member 51 abutting against the second annular sealing ring 4 is arranged on the guide rail 5. The abutting member 51 is obliquely arranged and is able to cooperate with the third inclined plane. The second annular sealing ring 4 cooperates with the abutting member 51 in the process of drawing the power module 1.

Further, an angle between the first inclined plane and the horizontal plane and an angle between the third inclined plane and the horizontal plane both range from 1.5 degrees to 5 degrees. These angles ensure that when the power module 1 slides along the guide rail 5, the first annular sealing ring 3 is tightly pressed with the fan connector 2, and the second annular sealing ring 4 is tightly pressed with the guide rail 5.

Further, an air duct docking interface 52 is defined on the guide rail 5, the air duct docking interface 52 is directly communicated with the second vent, and the abutting member 51 is arranged along a circumferential direction of the air duct docking interface 52. The heat is dissipated through the second vent and through the air duct docking interface 52 by the radiator, which facilitates the heat exchange between the heat generated by the module 11 and the atmosphere.

Further, a lower end surface of the module 11 is provided with a supporting plate 111, and the supporting plate 111 is slidably connected to the guide rail 5. The module 11 slides more smoothly relative to the guide rail 5 by arranging the supporting plate 111.

Further, the first annular sealing ring 3 and the second first annular sealing ring 4 are both made of rubber with acceptable mechanical property and acceptable aging resistance. The relatively harsh environment is able to be adapted through the use of rubber. In other embodiments, the first annular sealing ring 3 and the second first annular sealing ring 4 may be made of silica gel or other organic polymer materials, which is not limited here.

The main advantage of the drawer-type module sealing of the inverter are as follows.
1. Both the first annular sealing ring 3 and the second first annular sealing ring 4 are closed sealing rings, which ensures the reliability of the sealing.
2. The cooperating sliding structure of the guide rail 5 and the supporting plate 111 ensures that the first annular sealing ring 3 and the second first annular sealing ring 4 are evenly pressed when the power module 1 is mounted, which avoids a lower portion of the power module 1 is pressed and an upper portion of the power module 1 is slack caused by the gravity of the power module 1. At the same time, the cooperating structure of the guide rail 5 and the supporting plate 111 plays a role of guiding when the power module 1 is withdrawn or inserted, so as to avoid deviation from the pressing surface.
3. The power module 1 generally has a sheet metal splicing structure, the first annular sealing ring 3 is arranged on the power module 1 and presses a flat air duct connecter, and the air duct connecter is flat and seamless, which is beneficial to ensuring the first annular sealing ring 3 to be not cut to fail.

Apparently, the above embodiments of the present application are merely examples to clearly illustrate the present application, and are not intended to limit the implementation of the present application. For those skilled in the art, other changes or modifications in different forms can be made on the basis of the above description. It is unnecessary and impossible to list all the implementation methods here. Any modification, equivalent replacement and improvement made within the spirit and principle of the present application shall be included in the protection scope defined by the claims of the present application.

## Claims

1. A drawer-type module sealing structure of an inverter, comprising: a power module (1), a first annular sealing ring (3), a second annular sealing ring (4), and a fan connector (2), wherein
an upper end surface of the power module (1) is a first inclined plane, and an upper end of the power module (1) comprises a first vent (12), and a lower end of the power module (1) comprises a second vent;
the first annular sealing ring (3) is arranged at the first vent (12);
the second annular sealing ring (4) is arranged at the second vent; and
the fan connector (2) is arranged at the upper end of the power module (1), and a lower end surface of the fan connector (2) is a second inclined plane (21) which is configured to cooperate with the first inclined plane, and the second inclined plane (21) abuts against the first annular sealing ring (3).

2. The drawer-type module sealing structure of the inverter according to claim 1, comprising a guide rail (5), wherein the power module (1) is slidably arranged on the guide rail (5), and the second annular sealing ring (4) abuts against the guide rail (5).

3. The drawer-type module sealing structure of the inverter according to claim 2, wherein the power module (1) comprises a module (11) and a radiator, the radiator is arranged on the module (11), an upper end of the radiator comprises the first vent (12), a lower end of the radiator comprises the second vent, and the module (11) is slidably connected to the guide rail (5).

4. The drawer-type module sealing structure of the inverter according to claim 2, wherein a lower end surface of the power module (1) is a third inclined plane, and an upper end surface of the guide rail (5) is a fourth inclined plane which is configured to cooperate with the third inclined plane.

5. The drawer-type module sealing structure of the inverter according to claim 4, wherein an abutting member (51) abutting against the second annular sealing ring (4) is arranged on the guide rail (5), the abutting member (51) is obliquely arranged and is configured to cooperate with the third inclined plane.

6. The drawer-type module sealing structure of the inverter according to claim 5, wherein an air duct docking interface (52) is defined on the guide rail (5), the air duct docking interface (52) is directly communicated with the second vent, and the abutting member (51) is arranged along a circumferential direction of the air duct docking interface (52).

7. The drawer-type module sealing structure of the inverter according to claim 3, wherein the module (11) and the radiator have an integrated structure.

8. The drawer-type module sealing structure of the inverter according to claim 3, wherein a lower end surface of the module (11) is provided with a supporting plate (111), and the supporting plate (111) is slidably connected to the guide rail (5).

9. The drawer-type module sealing structure of the inverter according to claim 4, wherein an angle between the first inclined plane and the horizontal plane and an angle between the third inclined plane and the horizontal plane both range from 1.5 degrees to 5 degrees.

10. The drawer-type module sealing structure of the inverter according to claim 1, wherein the first annular sealing ring (3) and the second first annular sealing ring (4) are both made of rubber.
